# EUROPÄISCHE PATENTSCHRIFT

(11) **EP 0 890 172 B1**
(45) Veröffentlichungstag und Bekanntmachung des Hinweises auf die Patenterteilung: **07.06.2000**
(21) Anmeldenummer: 97918054.4
(22) Anmeldetag: 24.03.1997
(51) Int. Cl.: G11C 7/00, G11C 8/00

(54) **HALBLEITERSPEICHERVORRICHTUNG**
SOLID-STATE MEMORY DEVICE
MEMOIRE A SEMI-CONDUCTEURS

(30) Priorität: 28.03.1996 DE 19612439
(43) Veröffentlichungstag der Anmeldung: 13.01.1999
(73) Patentinhaber: SIEMENS AKTIENGESELLSCHAFT, 80333 München (DE)
(72) Erfinder: ZETTLER, Thomas, D-81737 München (DE); POCKRANDT, Wolfgang, D-85293 Reichertshausen (DE); WINNERL, Josef, D-81929 München (DE); GEORGAKOS, Georg, D-85447 Fraunberg (DE)
(86) Internationale Anmeldenummer: DE9700597
(87) Internationale Veröffentlichungsnummer: WO9737352

(56) Entgegenhaltungen:
- EP-A- 0 129 154
- US-A- 5 155 829
- US-A- 5 406 519

## Beschreibung

Die Erfindung bezieht sich auf eine Halbleiterspeichervorrichtung mit einer Vielzahl von auf einem Halbleitersubstrat an Kreuzungsstellen von Bitleitungen und Wortleitungen angeordneten Speicherzellen, die zur Programmierung mit Dateninhalten vermittels einer Wortleitungsansteuerschaltung und einer Bitleitungsansteuerschaltung ansteuerbar sind.

Eine solche Halbleiterspeichervorrichtung findet bevorzugt Anwendung in sogenannten Chipkarten, d.h. Ausweiskarten, Kreditkarten, Buchungskarten und dergleichen, welche mit einem integrierten Schaltkreis mit einem Mikroprozessor ausgestattet sind. Der Hersteller einer Chipkarte kann den Mikroprozessor mit einem fest gespeicherten Betriebssystem ausstatten, welches grundlegende Funktionen übernimmt, beispielsweises Prozeduren zum Vergleichen eines extern eingegebenen Codes mit einem gespeicherten Code und dergleichen. Die dem Mikroprozessor zugeordneten Speicher innerhalb der Chipkarte dienen außer zur Abspeicherung des Betriebssystems darüber hinaus zum Abspeichern bestimmter Anwendungen und Parameter, die beispielsweise zur Sicherheitsüberprüfung erforderlich sind und in jedem Fall geheimgehalten werden müssen. Eine derartige Chipkarte kann vielseitigen Anwendungen zugeführt werden, wenn herstellerseitig ein geeignetes Betriebssystem mit zugehörigen Programmen vorgesehen wird, bestimmte geeignete Schnittstellen vorgesehen werden und ein Speicher oder ein Speicherbereich für ein oder mehrere fremde Anwendungsprogramme reserviert wird. Auf diese Weise kann der Kartenhersteller für den Anwender der Chipkarte einen Speicher oder Speicherbereich zur Einprogrammierung eines fremden Anwenderprogrammes zur Verfügung stellen. In einem Anwenderprogramm können beispielsweise besondere Operationen festgelegt sein, die unabhängig vom Betriebssystem ablaufen und sich lediglich auf die besonderen Datenverarbeitungen des Anwenders beziehen. Bei einer besonders vielseitig verwendbaren Ausgestaltung einer Chipkarte kann darüber hinaus vorgesehen sein, daß mehrere unterschiedliche Anwender unabhängig voneinander ihre entsprechenden Programme in die Chipkarte einspeichern.

In jedem Fall muß wie bei allen sicherheitskritischen Datenverarbeitungssystemen, welche beispielsweise zur Verarbeitung von vertraulichen oder geldwerten Daten dienen, ein besonderer Schutz vor Datenmanipulation oder unbefugten Datenzugriffen vorgesehen werden. Daher ist dafür zu sorgen, daß sicherheitsrelevante Daten, die Bestandteil des Betriebssystems oder auch der einzelnen Anwenderprogramme sind, vor unbefugtem Zugriff geschützt werden. Bei einer Kreditkarte als Beispiel einer Chipkarte, welche eine integrierte Schaltung mit einem nichtflüchtigen Speicher (beispielsweise ein EEPROM oder ein ROM) und einen Mikroprozessor umfasst, ist es zur Sicherung vor Manipulationen erforderlich, daß ein im nichtflüchtigen Speicher gespeichertes Anwenderprogramm nicht unkontrolliert auf andere Anwenderprogramme oder Betriebssystemroutinen, die ebenfalls im nichtflüchtigen Speicher abgelegt sind, zugreifen kann.

Die Verhinderung solcher Zugriffe kann durch eine Sicherheitsschaltung für die Speicherzugriffsüberwachung gewährleistet werden, welche beispielsweise in der DE 41 15 152 A1 oder der US 5,452,431 bekannt geworden ist.

In der DE 41 15 152 A1 sind hierzu im wesentlichen drei unterschiedliche Maßnahmen erläutert. Bei einer ersten Maßnahme wird in der dargestellten Schaltung vor Ausführung des im EEPROM gespeicherten Anwenderprogrammes die Adresse, bei der das Anwenderprogramm im Speicherbereich beginnt, in zwei Hilfsregistern gespeichert. Während der Programmausführung wird laufend der aktuelle Adressbuswert mit dem ersten Hilfsregister, und der Programmzählerwert mit dem zweiten Hilfsregister verglichen. Aus einem ersten Vergleich wird ermittelt, ob ein Anwenderprogramm aktiv ist. Aus einem zweiten Vergleich wird geschlossen, ob gerade in einem für das Anwenderprogramm zulässigen Adressbereich gearbeitet wird. Für den Fall, daß ein Anwenderprogramm aktiv ist und nicht in einem zulässigen Bereich arbeitet, wird ein Reset-Signal im Mikroprozessor ausgelöst. Diese Maßnahme besitzt den Nachteil, daß die Schaltung zusätzliche Hilfsregister und Komparatoren für n Bits erfordert, wobei n die Adressbusbreite darstellt. Bei einer zweiten Maßnahme wird vorgeschlagen, den Programmzähler und den Adressbuswert durch einen zusätzlich vorgesehenen Kontrollprozessor mit eigenem Speicher zu überwachen. Wie bei der ersten Maßnahme wird ein Reset-Signal ausgelöst, wenn ein Anwenderprogramm auf einen nicht zugelassenen Adressbereich zugreift. Diese Schaltung besitzt den Nachteil, daß ein zusätzlicher Prozessor mit Speicher erforderlich ist. Bei einer dritten Maßnahme bzw. Schaltung besitzt jeder getrennt zu schützende Speicherbereich unterschiedliche höchstwertige Adressbits (Blockauswahl-Bits). Vor der Ausführung des in einem PROM-Block gespeicherten Anwenderprogrammes werden die Blockauswahl-Bits in einem Hilfsregister gespeichert. Während der Programmausführung werden laufend die höchstwertigen aktuellen Adressbusbits in einem zweiten Hilfsregister gespeichert und mit dem ersten Hilfsregister verglichen. Bei unterschiedlichem Inhalt der Hilfsregister wird gefolgert, daß das aktive Anwenderprogramm unzulässigerweise einen anderen Programmspeicherbereich adressiert. In der Folge wird ein Reset-Signal ausgelöst. Diese Schaltung besitzt den Nachteil, daß bei einer kleinen Anzahl von Bits (beispielsweise zwei Bits) nur eine starre gleichmäßige, relativ grobe Blockunterteilung (von beispielsweise einem Viertel des Gesamtspeichers) möglich ist. Weiterhin kann einem Fremdprogramm nur ein zusammenhängender Speicherbereich zugewiesen werden. Das Fremdprogramm mit dem größten Programmspeicherbedarf bestimmt damit die Blockgröße auch für die anderen Fremdprogramme, so daß die Speicherausnutzung insgesamt ungünstig ist.

Die US 5,452,431 zeigt eine Sicherheitsschaltung für die Speicherzugriffsüberwachung insbesondere zur Anwendung bei Chipkarten, bei welcher der Speicherbereich des EEPROM in einen Abschnitt ZR ("Repertory Region") und einen Anwendungsabschnitt ZA ("Application Region"), sowie einen öffentlichen Abschnitt ZP ("Public Region") unterteilt ist. Die Ansteuerung der unterschiedlichen Speicherbereiche ZR, ZA und ZP erfolgt getrennt vermittels einer Adressteuerschaltung dergestalt, daß jeweils bestimmte Adressbereiche den einzelnen Speicherbereichen zugeordnet werden, also feste Adressgrenzen vorbestimmt werden. Die Befehle zum Schreiben, Lesen und Löschen der jeweiligen Speicherbereiche können vermittels der Adressteuerschaltung im vorgegebenen Rahmen gesperrt oder freigegeben werden. Der Nachteil dieser Schaltung liegt darin, daß die Aufteilung des Speichers mit der Herstellung des EEPROM festliegt und vom Anwender nicht mehr geändert werden kann.

Aus der EP-A-0 129 054 ist eine Halbleiterspeichervorrichtung entsprechend dem Oberbegriff des Anspruchs 1 bekannt, der pro Wortleitung vier "Funktionsspeicherzellen" aufweist, die bestimmen, ob Daten einer Wortleitung schreib-, lese- oder löschgeschützt sind.

Der vorliegenden Erfindung liegt die Aufgabe zugrunde, eine Schaltung anzugeben, die mit einfachen Maßnahmen sicherstellt, daß seitens eines Fremdprogramms nur auf solche Speicherbereiche zugegriffen werden kann, die ausdrücklich für einen Zugriff zugelassen sind, und die gleichzeitig eine flexible Aufteilung der zugelassenen Speicherbereiche auf verschiedene Anwendungen erlaubt.

Diese Aufgabe wird durch eine Halbleiterspeichervorrichtung nach Anspruch 1 gelöst.

Erfindungsgemäß ist vorgesehen, daß den Speicherzellen einer Wortleitung entlang einer Freigabebitleitung angeordnete und vermittels einer separat und unabhängig von der Bitleitungsansteuerschaltung angeordneten und ansteuerbaren Freigabebitleitungsansteuerschaltung ansteuerbare Freigabespeicherzellen zugeordnet sind, die zur Freigabe der Speicherzellen einer vorbestimmten Wortleitung mit einem Freigabewert beaufschlagbar sind.

Die erfindungsgemäße Schaltung beruht auf einer besonderen Anordnung eines Halbleiterspeichers, welcher die einfache Überwachung der Speicherzugriffe und gleichzeitig eine flexible Aufteilung des Speichers bzw. der Speicherbereiche auf verschiedene Anwendungen erlaubt. Neben der Einstellung einer flexiblen Speichergröße bietet die Erfindung darüber hinaus den Vorteil einer freien absoluten Plazierung der zugewiesenen Speicherbereiche im Adressraum der Anwenderprogramme, so daß eine optimale Ausnutzung des insbesondere bei Chipkarten nur begrenzt zur Verfügung stehenden Speicherangebots gewährleistet ist. Gleichzeitig ermöglicht die Erfindung mit vergleichsweise geringem schaltungstechnischen Zusatzaufwand sicheren Schutz vor unbefugter Datenmanipulation oder unbefugten Datenzugriffen, wobei neben der Überwachung des Programmspeichers auch eine Überwachung der Datenspeicher durchgeführt werden kann.

Grundliegendes Prinzip der Erfindung ist die Erweiterung der Wortleitungen eines programmierbaren Halbleiterspeichers um m Bits, welche nicht im normalen Adressraum liegen, und welche Informationen über die Zugriffsrechte über die in den normalen Wortleitungsbits (page) gespeicherten Daten enthalten. Bei einer Anzahl von m Bits für die Freigabespeicherzellen können 2^{m} Anwendungen, d.h. Programm- bzw. Datenbereiche voneinander getrennt zur Ausführung kommen.

Bei einer bevorzugten Ausführung der Erfindung kann vorgesehen sein, daß die entlang der Kreuzungsstellen von Bitleitungen und Wortleitungen angeordneten Speicherzellen und die entlang von Kreuzungsstellen von Wortleitungen und Freigabebitleitungen angeordneten Freigabespeicherzellen vermittels einer in der Wortleitungsansteuerschaltung vorgesehenen Wortleitungstreiberschaltung gemeinsam angesteuert sind. Hierbei kann des weiteren zur Adressierung sowohl der Speicherzellen als auch der Freigabespeicherzellen eine gemeinsame Adressdekoderschaltung vorgesehen sein.

Die Erfindung bezieht sich somit auf einen besonders strukturierten Speicher, also keinen sogenannten Standardspeicher, bei dem neben Normalzellen die vorliegend als Freigabezellen bezeichneten Speicherzellen herstellerseitig vorgegeben sind, wobei die Freigabespeicherzellen mit den übrigen Wortleitungstreibern gekoppelt sind; Wortleitungstreiber und Adressdekoder sind somit gemeinsam für die Normalzellen und die Freigabezellen vorgesehen, wodurch sich eine erhebliche Flächenersparnis ergibt. Die unterschiedliche Ansteuerung von Normal- und Freigabezellen erfolgt lediglich durch unterschiedliche Bitleitungen.

In weiterer Ausgestaltung der Erfindung kann vorgesehen sein, daß eine Mikroprozessorschaltung zur Ausführung eines Betriebssystemprogrammes und wenigstens eines Anwenderprogrammes vorgesehen ist, welche Mikroprozessorschaltung bei Aufruf bzw. Ausführung eines Initialisierungsprogrammes ein Steuersignal an die Freigabebitleitungsansteuerschaltung ausgibt, vermittels welchem ein dem Anwenderprogramm zugewiesener Speicherbereich der Halbleiterspeichervorrichtung aktivierbar ist. Die Freigabezellen der zusätzlich vorgesehenen Freigabebitleitungen werden nicht auf normale Weise adressiert, sondern durch eine Initialisierungsschaltung gesetzt. Hierbei kann die Initialisierung beispielsweise so eingerichtet sein, daß sie nur einmal beim Laden des Betriebssystems möglich ist, und danach die Belegung der zusätzlichen Freigabezellen der Freigabebits nicht mehr veränderbar ist. Im Falle von einem zusätzlichen Freigabebit pro Seite (page), d.h. m = 1, können zwei Speicherbereiche getrennt werden, beispielsweise für zwei unterschiedliche Anwenderprogramme. Die Anzahl der Seiten, welche ein Anwenderprogramm belegt, kann hierbei beliebig wählbar sein. Ebenso kann die Plazierung der Anwenderprogramme im Gesamtspeicherbereich flexibel eingestellt werden, wobei auch eine ineinander verschachtelte Aufteilung der Speicherbereiche vorgenommen werden kann.

Bevorzugte Weiterbildungen der Erfindung ergeben sich aus den Unteransprüchen.

Weitere Merkmale, Vorteile und Zweckmäßigkeiten der Erfindung ergeben sich aus der Beschreibung von Ausführungsbeispielen anhand der beiliegenden Zeichnung. Es zeigt:
- Figur 1A: eine schematische Darstellung eines elektrisch programmierbaren und löschbaren Halbleiterspeichers zur Erläuterung der grundsätzlichen Wirkungsweise der Erfindung;
- Figur 1B: eine vereinfachte Blockdarstellung des in Figur 1A dargestellten Halbleiterspeichers gemäß Erfindung;
- Figur 2: eine schematische Darstellung einer Schaltung gemäß einem Ausführungsbeispiel der Erfindung;
- Figur 3: eine schematische Darstellung einer Schaltung gemäß einem weiteren Ausführungsbeispiel der Erfindung;
- Figur 4: eine schematische Darstellung einer Schaltung gemäß einem weiteren Ausführungsbeispiel der Erfindung;
- Figur 5: eine schematische Darstellung einer Schaltung gemäß einem weiteren Ausführungsbeispiel der Erfindung;
- Figur 6: eine schematische Darstellung einer Schaltung gemäß einem weiteren Ausführungsbeispiel der Erfindung; und
- Figur 7: eine schematische Darstellung einer Schaltung gemäß einem weiteren Ausführungsbeispiel der Erfindung.

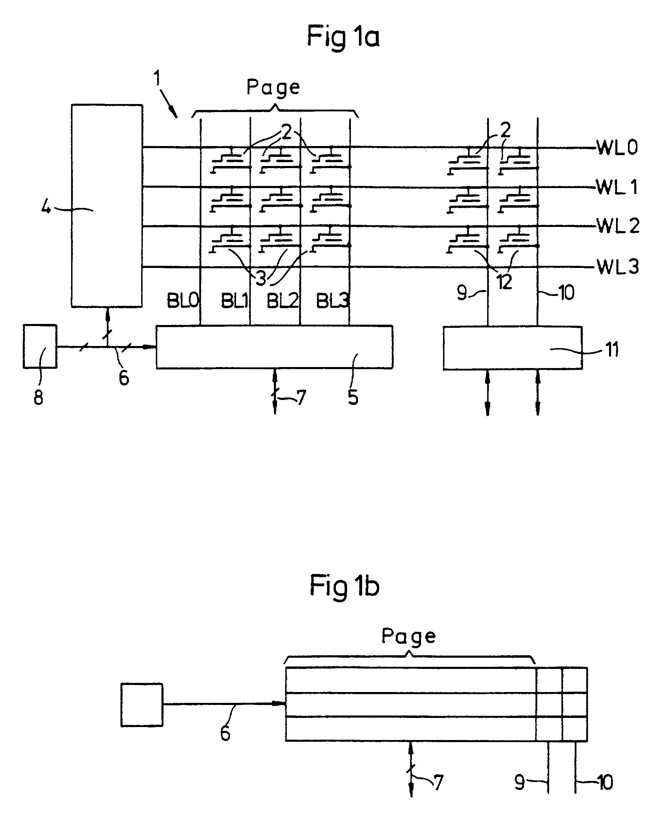

Figur 1A zeigt den Aufbau eines elektrisch veränderbaren Festwertspeichers 1 (EEPROM = Electrical Erasable Programmable ROM), dessen Vorteil bekanntlich darin besteht, daß die integrierte Schaltung löschbar und wieder programmierbar ist, ohne daß sie aus dem Anwendergerät entfernt werden muß und daß sich jedes einzelne Byte des Speichers mehrmals getrennt löschen und einschreiben läßt. Die Löschung erfolgt durch einen elektrischen Impuls. Als Speicherelement dienen Zellen 2 mit einer Steuerelektrode und einer potentialungebundenen Zwischenelektrode, welche als Ladungsspeicher wirkt. Die Wirkungsweise derartiger Festwertspeicher ist grundsätzlich bekannt und soll hier nicht näher erläutert werden. Die normalen Speicherzellen 3 der Halbleiterspeichervorrichtung 1 sind in großer Anzahl an Kreuzungsstellen von Bitleitungen BL und Wortleitungen WL angeordnet und vermittels einer Wortleitungsansteuerschaltung 4 und einer Bitleitungsansteuerschaltung 5 in der dem Fachmann geläufigen Weise ansteuerbar. Es ist ein Adressbus 6 und ein Datenbus 7 vorgesehen, auf dem die Adressen bzw. Daten zwischen den unterschiedlichen Schaltungsbestandteilen transportiert werden. Aus Gründen der einfacheren Darstellbarkeit ist für den Adressbus 6 und den Datenbus 7 jeweils nur eine Leitung gezeigt, wobei tatsächlich eine Vielzahl von Leitungen, beispielsweise 16 Leitungen vorgesehen sind. Ebensogut kann das Bussystem aus nur einer Leitung bestehen, wobei in diesem Fall die Adressen und Daten im Zeitmultiplexverfahren verarbeitet werden. In Figur 1A sind aus der in der Regel großen Anzahl von Wortleitungen lediglich vier Wortleitungen WL0 bis WL3, sowie lediglich vier Bitleitungen BL0 bis BL3 dargestellt. Die Bezugsziffer 8 bezeichnet schematisch einen Adressdekoder, dessen Aufbau und Wirkungsweise dem Fachmann ebenfalls geläufig ist und daher nicht näher erläutert werden soll.

Die erfindungsgemäße Sicherheitsschaltung basiert auf einer speziellen Anordnung bzw. Konstruktion des Speichers 1 nach Figur 1A und Figur 1B, welche die einfache Überwachung der Speicherzugriffe und eine flexible Aufteilung des Speichers 1 auf verschiedene Anwendungen erlaubt. Grundlegendes Prinzip der Erfindung ist die Erweiterung der Speicher-Wortleitung um m Bits, welche nicht im normalen Adressraum liegen, und welche Informationen über die Zugriffsrechte über die in den normalen Wortleitungsbits (Seiten bzw. pages) gespeicherten Daten enthalten. Hierzu sind m zusätzliche Bitleitungen 9 und 10 vorgesehen, die im folgenden als Freigabebitleitungen bezeichnet sind, und über eine Freigabebitleitungsansteuerschaltung 11 unabhängig von der (normalen) Bitleitungsansteuerschaltung 5 angesteuert werden können. An den Kreuzungsstellen der (normalen) Wortleitungen WL0 bis WL3 und den zusätzlich vorgesehenen Freigabebitleitungen 9 und 10 sind Freigabespeicherzellen 12 vorgesehen, die sich im Aufbau und der Wirkungsweise von den normalen Speicherzellen 3 nicht zu unterscheiden brauchen und daher zusammen mit den normalen Speicherzellen 3 hergestellt werden können. In den Freigabespeicherzellen werden in der nachfolgend noch zu erläuternden Weise Freigabewerte zeitweise oder dauerhaft abgelegt, die zur Freigabe der (normalen) Speicherzellen 3 einer oder mehrerer vorbestimmter Wortleitungen WL0 bis WL3 dienen.

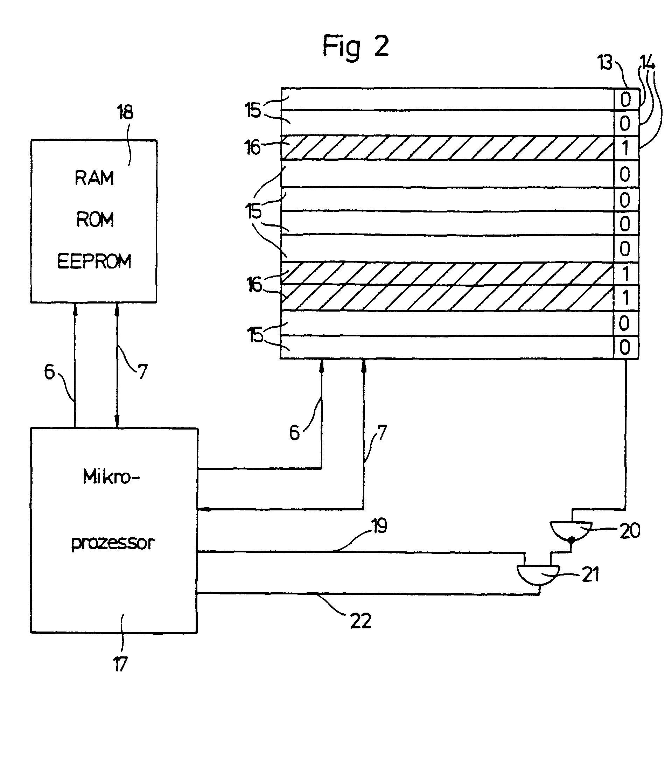

Figur 2 zeigt ein erstes Ausführungsbeispiel der Erfindung, bei dem eine einzige Freigabebitleitung 13 mit Freigabespeicherzellen 14 vorgesehen ist, d.h. m = 1. Die Dateninhalte der Freigabespeicherzellen 14 der einen Freigabebitleitung 13 sind nicht wie bei den (normalen) Speicherzellen 3 adressierbar, sondern werden durch eine in der Freigabebitleitungsansteuerschaltung 11 vorgesehene, in den Figuren nicht näher dargestellte Initialisierungsschaltung gesetzt. Die Initialisierung kann hierbei beispielsweise so eingerichtet sein, daß sie nur einmal beim Laden des Betriebssystems möglich ist. Danach ist die Belegung der zusätzlichen Freigabebits (ein Bit pro Seite bzw. page) nicht mehr veränderbar. Bei einem Bit pro page (m = 1) können zwei Speicherbereiche 15 und 16 getrennt voneinander ausgewählt werden, beispielsweise für zwei unterschiedliche Anwenderprogramme. Die Anzahl der Seiten (pages), welches ein Anwenderprogramm belegt, ist dabei beliebig wählbar. Ebenso ist die Plazierung der Anwenderprogramme im Gesamtspeicherbereich flexibel, wobei diese auch in ineinander verschachtelte Speicherbereiche aufgeteilt sein können. Der Speicherbereich 15 wird beispielsweise durch Einschreiben einer logischen Null in entsprechend zugeordnete Freigabespeicherzellen zugewiesen, während der Speicherbereich 16 durch Einschreiben eines logischen Wertes Eins definiert wird.

Dem Halbleiterspeicher 1 ist eine Mikroprozessorschaltung 17 zugeordnet, in welchem das Betriebssystem und die Anwenderprogramme aufgerufen bzw. durchgeführt werden, und welcher über den Adressbus 6 und den Datenbus 7 mit weiteren Speichern und Registern verbunden ist, beispielsweise RAM-, ROM-, oder EEPROM-Speichern, welche der Einfachheit halber einheitlich mit der Bezugsziffer 18 bezeichnet sind. Das im Mikroprozessor 17 ablaufende Betriebssystem besitzt die höchste Hierarchiestufe, Anwenderprogramme sind demgegenüber untergeordnet. Beim Aufruf eines Anwenderprogramms wird vom Mikroprozessor 17 ein Steuersignal gesetzt, welches auf einer Leitung 19 liegt. Dieser Vorgang kann nur durch das Betriebssystem ausgelöst werden. Auf diese Weise kann das Anwenderprogramm nur in dem ihm zugewiesenen Speicherbereich aktiv sein. Das Steuersignal des Mikroprozessors 17 zeigt somit an, ob ein Anwenderprogramm aktiv ist. Ohne weitere Hilfsregister wird dieses Steuersignal in einfacher Weise mit dem aktuellen Extrabit der Freigabebitleitung 13 verglichen. Zu diesem Zweck ist eine Vergleichsschaltung mit einem Inverter 20 und einem UND-Gatter 21 vorgesehen, welche in der in Figur 2 ersichtlichen Weise verschaltet sind. Eine Zwischenspeicherung der gesamten oder eines Teils der Adresse ist nicht erforderlich. Falls ein Anwenderprogramm aktiv ist, und auf einen unerlaubten Adressbereich zugreift, wird ein Resetsignal auf der Leitung 22 im Mikroprozessor 17 ausgelöst. Es ist jedoch ebenso möglich, mit dem Steuersignal den Mikroprozessor nicht zurückzusetzen, sondern eine andere geeignete Aktion auszulösen.

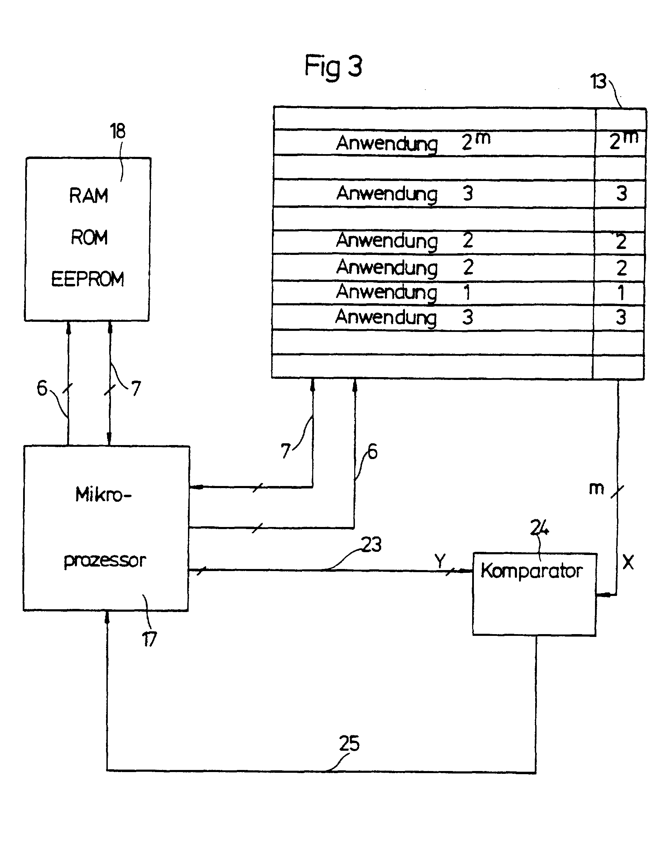

Figur 3 zeigt ein zweites Ausführungsbeispiel der Erfindung, bei dem gegenüber der ersten Ausführung in verallgemeinender Weise m zusätzliche Freigabebitleitungen 13 vorgesehen sind.

Wie beim ersten Ausführungsbeispiel sind die m zusätzlichen Bits pro Wortleitung WL0 bis WL3 nicht normal adressierbar, sondern werden durch eine Initialisierungsschaltung gesetzt. Die Initialisierungsschaltung für die zusätzlichen Bits der Freigabebitleitungen kann beispielsweise innerhalb der Freigabebitleitungsansteuerschaltung 11 (siehe Figur 1A) integriert sein. Die Initialisierung kann dabei wiederum so eingerichtet sein, daß sie nur ein einziges Mal beim Laden des Betriebssystems möglich ist, und danach die Belegung der Freigabespeicherzellen der zusätzlichen Freigabebitleitungen nicht mehr veränderbar ist. Bei einer Anzahl von m Freigabebitleitungen sind 2^{m} Programmbereiche separat für Anwenderprogramme trennbar, wobei die Anzahl der Seiten (pages), welche durch ein Anwenderprogramm belegt werden, beliebig wählbar ist, und auch die Plazierung der Anwenderprogramme im Gesamtspeicherbereich flexibel eingestellt werden kann, insbesondere auch in einer ineinander verschachtelten Aufteilung der Speicherbereiche. Wiederum besitzt das Betriebssystem die höchste Hierarchiestufe, Anwenderprogramme sind demgegenüber untergeordnet. Beim Aufruf eines Anwenderprogramms wird eine Gruppe von Steuersignalen bzw. ein Steuersignalvektor auf der Leitung 23 gesetzt, welcher Vorgang nur durch das Betriebssystem ausgelöst werden kann. Auf diese Weise kann das jeweilige Anwenderprogramm nur in dem ihm zugewiesenen Speicherbereich aktiv sein. Der Steuersignalvektor des Mikroprozessors 17 zeigt hierbei an, welche der maximal möglichen 2^{m} Anwendungen aktiv sind. Vor dem Start der jeweiligen Anwendung wird der der Anwendung zugeordnete m-Bitwert Y gesetzt. Der Wert Y wird bei jedem Speicherzugriff mit dem aktuellen zusätzlichen Freigabebitinhalt X vermittels eines Komparators 24 verglichen. Gilt Y ungleich X, so liegt ein unerlaubter Zugriff vor, und es wird als Reaktion hierauf ein geeignetes Steuersignal, beispielsweise ein Reset-Signal auf der Leitung 25 erzeugt, welches den Mikroprozessor 17 zurücksetzt.

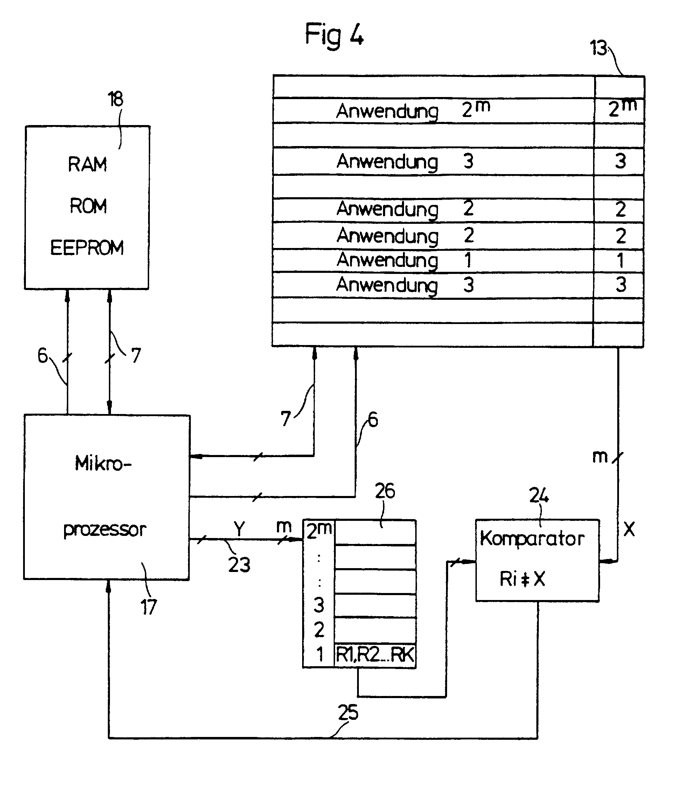

Figur 4 zeigt ein drittes Ausführungsbeispiel der Erfindung, welches gegenüber dem zweiten Ausführungsbeispiel durch einen zusätzlichen Speicher 26 erweitert ist, dem sogenannten Zugriffsrechttabellenspeicher. Wiederum sind die m zusätzlichen Freigabebits pro Wortleitung WL0 bis WL3 nicht auf normale Weise adressierbar, sondern werden durch eine Initialisierungsschaltung gesetzt. Darüber hinaus wird die Belegung des Zugriffsrechtstabellenspeichers 26 in der Initialisierungsphase festgelegt. Die Initialisierungsschaltung für die zusätzlichen Freigabebits kann beispielsweise wiederum innerhalb der Freigabebitleitungsansteuerschaltung 11 integriert ausgebildet sein (siehe Figur 1A). Die Initialisierung kann dabei ebenfalls so eingerichtet sein, daß sie nur einmal beim Laden des Betriebssystems möglich ist. Danach ist die Belegung der zusätzlichen Freigabebits und des Zugriffsrechtstabellenspeichers nicht mehr veränderbar. Bei m zusätzlichen Freigabebits sind wiederum 2^{m} Programmbereiche trennbar, wobei die Anzahl der Seiten (pages), welche ein Anwenderprogramm belegt, beliebig wählbar, die Plazierung der Programme im Gesamtspeicherbereich flexibel ist, und wiederum eine ineinander verschachtelte Aufteilung der Speicherbereiche möglich ist. Das Betriebssystem besitzt die höchste Hierarchiestufe, Anwenderprogramme sind untergeordnet. Bei Aufruf eines Anwenderprogramms wird ein Steuersignal gesetzt, bei dem dritten Ausführungsbeispiel nach Figur 4 wiederum eine Gruppe von Steuersignalen bzw. ein Steuersignalvektor. Dieser Vorgang kann nur durch das Betriebssystem ausgelöst werden, so daß auf diese Weise das Anwenderprogramm nur in dem ihm zugewiesenen Speicherbereich aktiv sein kann. Der Steuersignalvektor des Mikroprozessors 17 zeigt wiederum an, welche der maximal möglichen 2^{m} Anwendungen aktiv ist. Vor dem Start der Anwendung wird der der Anwendung zugeordnete m-Bitwert Y gesetzt. Der Wert wird in der Zugriffsrecht-Tabelle des Speichers 26 decodiert, welcher ein separater Speicher mit allerdings kleinerer Speicherzahl sein kann. Die der jeweiligen Anwendung Y zugeordneten k Einträge R1, ..., Rk werden vermittels dem Komparator 24 mit dem aktuell zusätzlichen Freigabebitinhalt X verglichen. Gilt für sämtliche Ri, Ri ungleich X, so liegt ein unerlaubter Zugriff vor. Als Reaktion wird ein geeignetes Steuersignal, beispielsweise ein Reset-Signal auf der Leitung 25 erzeugt. Die Einführung des Zugriffsrechtstabellenspeichers 26 erlaubt eine beliebige Festlegung der gegenseitigen Zugriffsrechte der Anwendungen. Auf diese Weise ist es möglich, daß eine Anwendung A auf eine Anwendung B zugreifen darf, nicht aber beispielsweise die Anwendung B auf die Anwendung A.

Beim Aufruf von Anwenderprogrammen durch das Betriebssystem muß sichergestellt sein, daß die datenschützenden Prozessorsteuersignale rechtzeitig beim Start der Anwendung gesetzt, und beim Verlassen der Anwendung wieder gelöscht werden. Dies kann beispielsweise folgendermaßen geschehen: Setzt das Betriebssystem die Steuersignale vor dem Sprung ins Anwenderprogramm, so wird der Sprungbefehl als Teil des Anwenderprogramms markiert. Ebenso kann der Mikroprozessor 17 den Sprungbefehl in den Anwenderprogrammbereich automatisch erkennen, und die entsprechenden Steuersignale setzen.

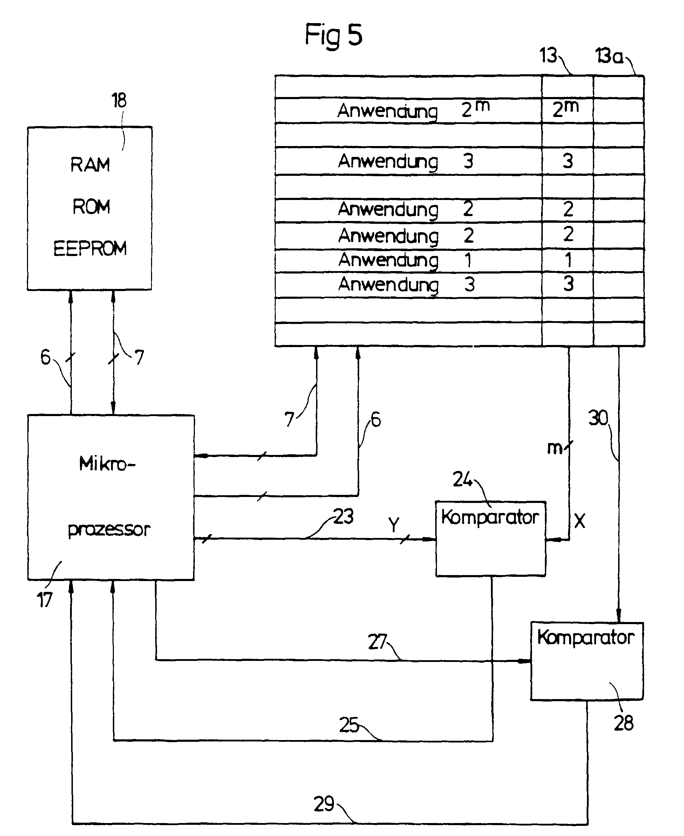

Figur 5 zeigt ein weiteres Ausführungsbeispiel der Erfindung, welche die Festlegung der Aktionsrechte der Anwenderprogramme wie insbesondere hinsichtlich der Aktionen Lesen, Schreiben und Löschen ermöglicht. Zu diesem Zweck verfügt der Halbleiterspeicher über eine Anzahl n von zusätzlichen Freigabebitleitungen 13a zur Festlegung der möglichen Aktionen, sowie einen über eine Leitung 30 mit den zusätzlichen n Freigabebitleitungen 13a verbundenen Komparator 28, der über Leitungen 27 und 29 mit dem Mikroprozessor 17 in Kontakt steht. Bei der Initialisierung wird durch entsprechendes Setzen der Freigabespeicherzellen der zusätzlichen Freigabebitleitungen 13a festgelegt, welche Aktionen ein Anwenderprogramm, d.h. Lesen, Schreiben oder Löschen in dem jeweils zugeteilten Speicherbereich ausführen darf. Bei einer Verletzung des Aktionsstatus durch das Anwenderprogramm, welcher durch den Mikroprozessor 17 durch das auf der Leitung 27 liegende Aktionsstatussignal angezeigt bzw. vorgegeben ist, kann durch das vom Komparator 28 auf der Leitung 29 ausgegebene Steuersignal beispielsweise ein Reset des Mikroprozessors 17 veranlaßt werden.

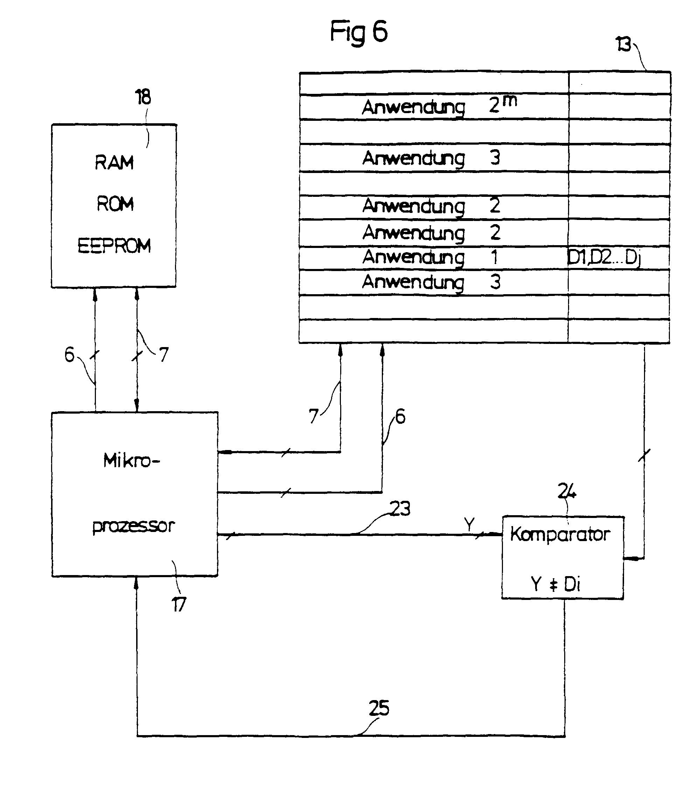

Figur 6 zeigt ein weiteres Ausführungsbeispiel der Erfindung, bei dem die gemäß Figur 4 erläuterte Zugriffsrechttabelle 26 in schaltungstechnisch besonders einfacher Weise gleich in die Freigabespeicherzellen einer Anzahl von k Freigabebitleitungen 13 (hierbei ist k gleich oder kleiner als m) integriert ausgebildet ist.

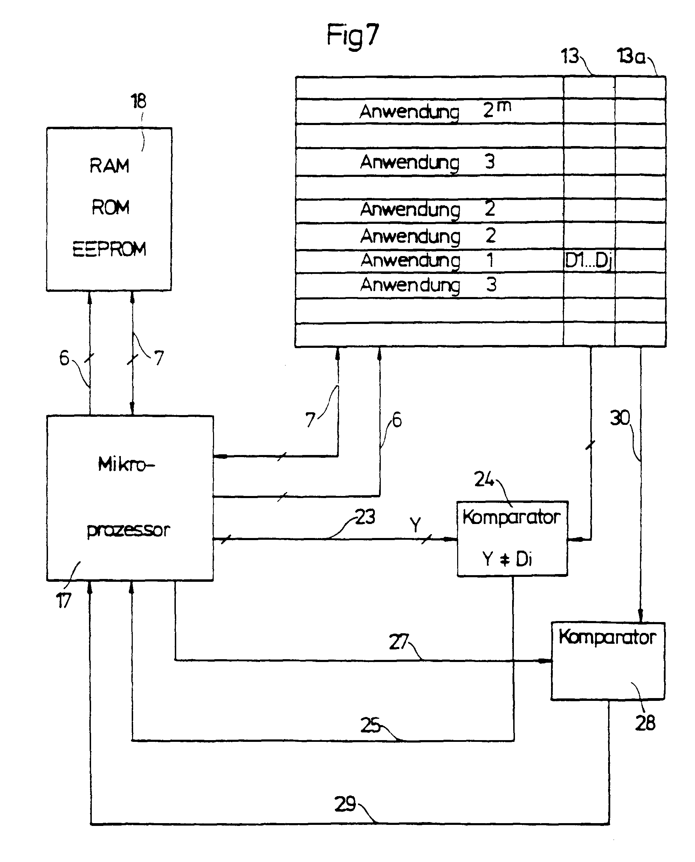

Bei dem in Figur 7 dargestellten Ausführungsbeispiel sind die vorteilhaften Merkmale aus den Ausführungsbeispielen nach Figur 5 und Figur 6 kombiniert.

Durch die erfindungsgemäße Schaltung kann neben der Festlegung von Zugriffsrechten für Programmcode-Bereiche darüber hinaus auch eine Regelung des Zugriffs auf Datenspeicherbereiche erfolgen.

## Patentansprüche

1. Halbleiterspeichervorrichtung mit einer Vielzahl von auf einem Halbleitersubstrat an Kreuzungsstellen von Bitleitungen und Wortleitungen angeordneten Speicherzellen (3), die zur Programmierung mit Dateninhalten vermittels einer Wortleitungsansteuerschaltung (4) und einer Bitleitungsansteuerschaltung (5) ansteuerbar sind, wobei den Speicherzellen (3) einer Wortleitung (WL0 bis WL3) entlang einer Freigabebitleitung (9, 10, 13) angeordnete und vermittels einer separat und unabhängig von der Bitleitungsansteuerschaltung (5) angeordneten und ansteuerbaren Freigabebitleitungsansteuerschaltung (11) ansteuerbare Freigabespeicherzellen (12, 14) zugeordnet sind, die zur Freigabe der Speicherzellen (3) einer zugeordneten Wortleitung (WL0 bis WL3) mit einem Freigabewert beaufschlagbar sind, und wobei eine Anzahl von m Freigabebitleitungen (9, 10, 13) für die frei wählbare Belegung einer Anzahl von 2^{m} Programmbereichen von Speicherzellen (3) der Halbleiterspeichervorrichtung (1) vorgesehen ist,
dadurch gekennzeichnet, daß
die Halbleiterspeichervorrichtung einen Komparator (24) aufweist, dessen einer Eingang (X) mit den Freigabebitleitungen (9, 10, 13) verbunden ist und an dessen anderen Eingang (Y) ein Steuersignal (23) von einer Mikroprozessorschaltung (17) legbar ist, wobei der Komparator (24) bei Ungleichheit der Werte an seinen beiden Eingängen ein Ausgangssignal (25) erzeugt.

2. Halbleiterspeichervorrichtung nach Anspruch 1, dadurch gekennzeichnet, daß ein Zugriffsrechttabellenspeicher (26) zur Speicherung einer Zugriffsrechttabelle für die Festlegung der Zugriffsrechte der 2^{m} Programmbereiche vorgesehen ist.

3. Halbleiterspeichervorrichtung nach Anspruch 2, dadurch gekennzeichnet, daß die Zugriffsrechttabelle innerhalb einer Anzahl von k Freigabebitleitungen integriert ist (Fig. 6).

4. Halbleiterspeichervorrichtung nach Anspruch 1 bis 3, dadurch gekennzeichnet, daß die entlang der Kreuzungsstellen von Bitleitungen und Wortleitungen angeordneten Speicherzellen (3) und die entlang von Kreuzungsstellen von Wortleitungen und Freigabebitleitungen (9, 10, 13) angeordneten Freigabespeicherzellen (12, 14) vermittels einer in der Wortleitungsansteuerschaltung (4) vorgesehenen Wortleitungstreiberschaltung gemeinsam angesteuert sind.

5. Halbleiterspeichervorrichtung nach Anspruch 1 bis 4, dadurch gekennzeichnet, daß zur Adressierung sowohl der Speicherzellen (3) als auch der Freigabespeicherzellen (12, 14) eine gemeinsame Adressdekoderschaltung vorgesehen ist.

6. Halbleiterspeichervorrichtung nach Anspruch 1 bis 5, dadurch gekennzeichnet, daß die Freigabebitleitungsansteuerschaltung (11) eine Initialisierungsschaltung zur Festlegung der Freigabewerte der Freigabespeicherzellen (12, 14) einer Freigabebitleitung (9, 10, 13) besitzt.

7. Halbleiterspeichervorrichtung nach Anspruch 1 bis 6, dadurch gekennzeichnet, daß eine Mikroprozessorschaltung (17) zur Ausführung eines Betriebssystemprogrammes und wenigstens eines Anwenderprogrammes vorgesehen ist, welche Mikroprozessorschaltung (17) bei Aufruf bzw. Ausführung eines Initialisierungsprogrammes ein Steuersignal an die Freigabebitleitungsansteuerschaltung (11) ausgibt, vermittels welchem ein dem Anwenderprogramm zugewiesener Speicherbereich (15, 16) der Halbleiterspeichervorrichtung (1) aktivierbar ist.

8. Halbleiterspeichervorrichtung nach Anspruch 7, dadurch gekennzeichnet, daß die Mikroprozessorschaltung (17) bei Aufruf bzw. Ausführung eines Anwenderprogrammes ein Steuersignal über eine oder mehrere Steuerleitungen (19, 23) an einen Komparator (24) anlegt, der mit einer oder mehreren Freigabebitleitungen (13) verbunden ist, und seinerseits ein Steuersignal (22, 25) an den Mikroprozessor (17) ausgibt, falls das Anwenderprogramm eine Zugriffsrechtverletzung oder Aktionsrechtverletzung bewirkt, wobei der Begriff "Aktion" die Funktionen Lesen, Schreiben, oder Löschen umfasst.

9. Halbleiterspeichervorrichtung nach Anspruch 1 bis 8, dadurch gekennzeichnet, daß zusätzlich eine Anzahl von n Freigabebitleitungen zur Festlegung der möglichen Aktionen, d.h. Funktionen Lesen, Schreiben, oder Löschen vorgesehen sind (Fig. 5).

10. Chipkarte mit einer Mikroschaltung, die eine Halbleiterspeichervorrichtung nach den Ansprüchen 1 bis 9 enthält.

## Claims

1. Semiconductor storage device with a large number of storage cells (3), arranged on a semiconductor substrate at intersections of bit lines and word lines, which, for programming with data contents, can be driven by means of a word-line drive circuit (4) and a bit-line drive circuit (5), enable storage cells (12, 14), arranged along an enable bit line (9, 10, 13) and driveable by means of an enable bit-line drive circuit (11) which is arranged and can be driven separately and independently of the bit-line drive circuit (5), being assigned to the storage cells (3) of a word line (WL0 to WL3) and able to have an enable value applied to them in order to enable the storage cells (3) of a predetermined word line (WL0 to WL3), and a number of m enable bit lines (9, 10, 13) being provided for the freely selectable reservation of a number of 2^{m} program regions of storage cells (3) of the semiconductor storage device (1), characterized in that the semiconductor storage device has a comparator (24) whose one input (X) is connected to the enable bit lines (9, 10, 13) and to whose other input (Y) a control signal (23) can be applied by a microprocessor circuit (17), the comparator (24) producing an output signal (25) when the values at its two inputs are unequal.

2. Semiconductor storage device according to Claim 1, characterized in that an access-right table memory (26) is provided for storing an access-right table for establishing the access rights of the 2^{m} program regions.

3. Semiconductor storage device according to Claim 2, characterized in that the access-right table is integrated within a number of k enable bit lines (Fig. 6).

4. Semiconductor storage device according to one of Claims 1 to 3, characterized in that the storage cells (3) arranged along the intersections of bit lines and word lines, and the enable storage cells (12, 14) arranged along the intersections of word lines and enable bit lines (9, 10, 13), are driven in common by means of a word-line driver circuit provided in the word-line drive circuit (4).

5. Semiconductor storage device according to one of Claims 1 to 4, characterized in that a common address-decoder circuit is provided for addressing both the storage cells (3) and the enable storage cells (12, 14).

6. Semiconductor storage device according to one of Claims 1 to 5, characterized in that the enable bit-line drive circuit (11) has an initialization circuit for establishing the enable values of the enable storage cells (12, 14) of an enable bit line (9, 10, 13).

7. Semiconductor storage device according to one of Claims 1 to 6, characterized in that a microprocessor circuit (17) is provided for executing an operating-system program and at least one user program, which microprocessor circuit (17), on calling or executing an initialization program, emits to the enable bit-line drive circuit (11) a control signal by means of which a storage area (15, 16) of the semiconductor storage device (1), allocated to the user program, can be activated.

8. Semiconductor storage device according to Claim 7, characterized in that the microprocessor circuit (17), on calling or executing a user program, applies a control signal via one or more control lines (19, 23) to a comparator (24) which is connected to one or more enable bit lines (13) and, for its part, emits a control signal (22, 25) to the microprocessor (17) should the user program commit an access-right violation or action-right violation, the term "action" covering the functions of reading, writing or erasing.

9. Semiconductor storage device according to one of Claims 1 to 8, characterized in that a number of n enable bit lines for establishing the possible actions, i.e. the functions of reading, writing or erasing, are additionally provided (Fig. 5).

10. Chip card with a microcircuit that contains a semiconductor storage device according to Claims 1 to 9.

## Revendications

1. Dispositif de mémoire à semi-conducteurs avec une pluralité de cellules de mémoire (3) disposées sur un substrat semi-conducteur aux points d'intersection de lignes de bit et de lignes de mot, lesquelles cellules de mémoire (3) peuvent être commandées au moyen d'un circuit de commande de ligne de mot (4) et d'un circuit de commande de ligne de bit (5) pour la programmation avec des contenus de données, des cellules de mémoire de validation (12, 14) étant attribuées aux cellules de mémoire (3) d'une ligne de mot (WL0 à WL3), qui sont disposées le long d'une ligne de bit de validation (9, 10, 13) et peuvent être commandées au moyen d'un circuit de commande de ligne de bit de validation (11) disposé séparément et pouvant être commandé indépendamment du circuit de commande de ligne de bit (5), et qui, en vue de la validation des cellules de mémoire (3) d'une ligne de mot (WL0 à WL3) attribuée, peuvent se voir appliquer une valeur de validation, et un nombre de m lignes de bit de validation (9, 10, 13) étant prévues pour l'occupation discrétionnaire d'un nombre de 2^{m} zones de programme de cellules de mémoire (3) du dispositif de mémoire à semi-conducteurs (1), caractérisé en ce que le dispositif de mémoire à semi-conducteurs comporte un comparateur (24), dont une entrée (X) est reliée aux lignes de bit de validation (9, 10, 13) et dont l'autre entrée (Y) peut se voir appliquer un signal de commande (23) d'un microprocesseur à circuit intégré (17), le comparateur (24) générant un signal de sortie (25) à ses deux entrées en cas d'inégalité des valeurs.

2. Dispositif de mémoire à semi-conducteurs selon la revendication 1, caractérisé en ce qu'une mémoire à table de droit d'accès (26) est prévue, destinée au stockage d'une table de droit d'accès pour la définition des droits d'accès des 2^{m} zones de programme.

3. Dispositif de mémoire à semi-conducteurs selon la revendication 2, caractérisé en ce que la table de droit d'accès est intégrée dans un nombre de k lignes de bit de validation (fig. 6).

4. Dispositif de mémoire à semi-conducteurs selon les revendications 1 à 3, caractérisé en ce que les cellules de mémoire (3) disposées le long des points d'intersection de lignes de bit et de lignes de mot et les cellules de mémoire de validation (12, 14) disposées le long de points d'intersection de lignes de mot et de lignes de bit de validation (9, 10, 13) sont commandées ensemble au moyen d'un circuit d'attaque de ligne de mot prévu dans le circuit de commande de ligne de mot (4).

5. Dispositif de mémoire à semi-conducteurs selon les revendications 1 à 4, caractérisé en ce qu'un circuit de décodage d'adresse commun est prévu pour l'adressage à la fois des cellules de mémoire (3) et des cellules de mémoire de validation (12, 14).

6. Dispositif de mémoire à semi-conducteurs selon les revendications 1 à 5, caractérisé en ce que le circuit de commande de ligne de bit de validation (11) possède un circuit d'initialisation pour définir les valeurs de validation des cellules de mémoire de validation (12, 14) d'une ligne de bit de validation (9, 10, 13).

7. Dispositif de mémoire à semi-conducteurs selon les revendications 1 à 6, caractérisé en ce qu'un microprocesseur à circuit intégré (17) est prévu pour exécuter un programme du système d'exploitation et au moins un programme utilisateur, lequel microprocesseur à circuit intégré (17), en cas d'appel resp. d'exécution d'un programme d'initialisation, envoie un signal de commande au circuit de commande de ligne de bit de validation (11), au moyen duquel une zone de mémoire (15, 16) du dispositif de mémoire à semi-conducteurs (1) assignée au programme utilisateur peut être activée.

8. Dispositif de mémoire à semi-conducteurs selon la revendication 7, caractérisé en ce qu'en cas d'appel resp. d'exécution d'un programme utilisateur, le microprocesseur à circuit intégré (17) applique via une ou plusieurs lignes de commande (19, 23) un signal de commande à un comparateur (24), qui est relié à une ou plusieurs lignes de bit de validation (13) et qui envoie de son côté un signal de commande (22, 25) au microprocesseur (17) si le programme utilisateur effectue une violation du droit d'accès ou violation du droit d'action, le terme "action" englobant les fonctions lire, écrire et effacer.

9. Dispositif de mémoire à semi-conducteurs selon les revendications 1 à 8, caractérisé en ce qu'un nombre de n lignes de bit de validation sont prévues en supplément pour définir les possibles actions, c.-à.-d. lire, écrire ou effacer (fig. 5).

10. Carte à puce dotée d'un microcircuit contenant un dispositif de mémoire à semi-conducteurs selon les revendications 1 à 9.
